# EUROPEAN PATENT APPLICATION

(11) **EP 2 034 528 A1**
(43) Date of publication of application: **11.03.2009**
(21) Application number: 07744305.9
(22) Date of filing: 29.05.2007
(51) Int. Cl.: H01L 33/00, H01L 23/12, H01L 23/34

(54) **ELECTRONIC COMPONENT**

(30) Priority: 15.06.2006 JP 2006166175
(71) Applicant: Sanyo Electric Co., Ltd., Osaka 570-8677 (JP); Matsuoka, Yoichi, Izumi-Shi, Osaka 594-0041 (JP)
(72) Inventor: MATSUOKA, Yoichi, c/o Sanyo Electric Co., Ltd., Moriguchi-Shi, Osaka 5708677 (JP); NAKAHARA, Toshinori, c/o Sanyo Electric Co., Ltd., Moriguchi-Shi, Osaka 5708677 (JP); TAKIGAWA, Keiko, c/o Sanyo Electric Co., Ltd., Moriguchi-Shi, Osaka 5708677 (JP); MATSUMOTO, Akihisa, c/o Sanyo Electric Co., Ltd., Moriguchi-Shi, Osaka 5708677 (JP)
(74) Representative: Glawe, Delfs, Moll
(86) International application number: PCT/JP2007/060885
(87) International publication number: WO 2007/145074

(57) **Abstract**

An electronic component (1) is provided with a circuit board (2) having a plurality of electrodes on the upper and lower planes of an insulating substrate, and a circuit element (7) fixed to the upper plane of the circuit board (2). The electronic component is also provided with an upper electrode (4) whereupon a circuit element (7) is to be arranged; a through hole (13) penetrating the insulating substrate (12); and a lower electrode (15), which is formed on the lower side ranging from a first side end (20A) of the circuit board (2) to a sectional side end (20B) facing the first side end (20A) and carries electricity to the upper electrode (4) through the through hole (13).

## Description

### Technical Field of the Invention

The present invention relates to an electronic component having a frame fixed on the upper surface of a circuit board, and more specifically to an electronic component suitable for a surface-mounted LED used as a light source for switch internal illumination, an LED display, a backlight light source, an optical printer head, a camera flash, or the like.

### Background Art

Patent Document 1 discloses a surface-mounted LED as a conventional electronic component. FIG. 14 is a sectional view showing this surface-mounted LED. The surface-mounted LED has electrodes 102 and 103 provided on the upper surface side and lower surface side of an insulating substrate 101. The electrodes 102 and 103 are connected to each other by a through hole 104. Below an opening of the insulating substrate 101, an electrode 105 is provided, which is mounted with an LED element 106 with a conducting material. The front side electrode of the LED element 106 and the electrode 102 are connected together with a thin metal wire 107.

On the circumference portion of the surface-mounted LED, a reflective frame 108 as a frame is provided. The reflective frame 108 is typically formed of an insulating material as a resin material, and is fixed on the electrodes 102 and 105 with an adhesive 110. In the opening part of the reflective frame 108, transmissive resin 109 is filled. This encapsulates the LED element 106 and the thin metal wire 107.

Moreover, a surface-mounted LED is known which has the reflective frame 108 formed of a metal member for heat radiation. This surface-mounted LED has an insulating film provided on the surfaces of 102 and 105 for the purpose of preventing short circuit of polar electrodes.

[Patent Document 1] JP-A-H7-235696 (FIG. 8)

### Disclosure of the Invention

### Problem to be Solved by the Invention

The electronic component of this type has an electrode 105 provided below an opening of an insulating substrate 101 and equipped with an LED element 106 with a conducting material, so that heat generated by the LED element 106 is radiated via the electrode 105. However, the electrode 105 has low degree of freedom in arrangement, which has raised a problem that sufficient heat radiation effect cannot be provided.

It is an object of the invention to provide an electronic component that can improve heat radiation performance.

### Means for Solving the Problem

To solve the problem described above, the present invention refers to an electronic component including a circuit board having a plurality of electrodes on upper and lower surface of an insulating substrate and a thermogenic circuit element fixed to an upper surface of the circuit board. The electronic component further includes: an upper electrode on which the circuit element is placed; a through hole penetrating through the insulating substrate; and a lower electrode formed on a lower surface side in a range from a first side end of the circuit board to a second side end thereof opposing the first side end, the lower electrode being connected to the upper electrode via the through hole.

With this configuration, the upper electrode is formed on the upper surface of the insulating substrate forming the circuit board, and the lower electrode connected to the upper electrode via the through hole is formed on the lower surface of the insulating substrate. The lower electrode is formed over an opposing pair of first and second side ends. The circuit element is placed on the upper electrode, and heat generated by the circuit element is radiated via the upper electrode and the lower electrode.

Preferrably, in the electronic component with the configuration described above, the upper electrode and the lower electrode are adapted to be electrically nonpolar.

Preferrably, in the electronic component with the configuration described above, terminal sections of a plurality of polar electrodes are arranged along opposing third and fourth side ends extending in a direction crossing the first and second side ends. With this configuration, the polar electrodes are disposed at both side parts of the lower electrode formed over the first and second side ends, and a voltage is applied to the circuit element via the terminal sections of the polar electrodes.

Preferrably, in the electronic component with the configuration described above, the lower electrode has a wider area than each of the polar electrodes.

Preferrably, in the electronic component with the configuration described above, the terminal sections of the polar electrodes are arranged along the third side end extending in the direction crossing the first and second side ends, and the lower electrode is provided in a manner such as to extend to the fourth side end opposing the third side end. With this configuration, the polar electrodes are disposed at one side part of the lower electrode formed over the first and second side ends, and a voltage is applied to the circuit element via the terminal sections of the polar electrodes.

Preferrably, in the electronic component with the configuration described above, the upper electrode and the lower electrode are grounded.

Preferrably, in the electronic component with the configuration described above, a depression in a shape along the through hole is formed on a surface of the lower electrode.

Preferrably, in the electronic component with the configuration described above, a joint surface between the upper electrode and the lower electrode is composed of an upper surface of the through hole.

Preferrably, in the electronic component with the configuration described above, the depression is arranged near the first and second side ends.

Preferrably, in the electronic component with the configuration described above, a frame enclosing the surrounding of the circuit element and composed of a good heat conductor is provided in contact with the upper electrode.

Preferrably, in the electronic component with the configuration described above, the circuit element is composed of an LED element, and emitted light of the LED element is reflected by the frame.

### Advantages of the Invention

According to the present invention, since a lower electrode connected via a through hole to an upper electrode on which a circuit element is placed is formed over opposing first and second side ends of a circuit board, a wide area of the lower electrode can be ensured. As a result, heat generated by the circuit element can be efficiently radiated via the upper electrode and the lower electrode, which permits improvement in the heat radiation performance of an electronic component.

According to the present invention, since the upper electrode and the lower electrode are adapted to be electrically nonpolar, the degree of freedom in arrangement for the upper electrode and the lower electrode can be made higher than for the polar electrodes. Therefore, the electronic component with high heat radiation performance can easily be achieved.

According to the invention, since terminal sections of a plurality of polar electrodes are arranged along opposing third and fourth side ends extending in a direction crossing the first and second side ends, an electronic component can easily be achieved which supplies power to the circuit element via the terminal sections of the polar electrodes and which has high heat radiation performance. Moreover, since the polar electrodes and the lower electrode are arranged in distinction from each other, wiring to the terminal sections of the polar electrodes can easily be performed. Therefore, operability in assembling a device loaded with the electronic component can be improved.

According to the invention, since the lower electrode has a wider area than each of the polar electrodes, the heat radiation performance of the electronic component can be improved.

According to the invention, since the terminal sections of the polar electrodes are arranged along the third side end extending in the direction crossing the first and second side ends and the lower electrode is provided in a manner such as to extend to the fourth side end opposing the third side end, the area of the lower electrode can be made even larger. Therefore, the heat radiation performance of the electronic component can be further improved.

According to the invention, since the upper electrode and the lower electrode are grounded, one terminal of the circuit element can be connected to the upper electrode having a wide area. Therefore, operability in assembling the electronic component can be improved.

According to the invention, since a depression in a shape along the through hole is formed on a surface of the lower electrode, the heat radiation area can be more increased to further improve the heat radiation performance. Moreover, upon mounting the electronic component by soldering the lower electrode, the solder joint area can be increased to improve joint strength. Further, since solder is embedded in the depressions during soldering, the metal volume increases, which enlarges a heat conduction path, resulting in smooth heat radiation, which permits further improvement in the heat radiation performance.

According to the invention, since a joint surface between the upper electrode and the lower electrode is composed of an upper surface of the through hole, the depression can easily be formed by forming the lower electrode on an insulating substrate formed with the through hole.

According to the invention, since the depression is arranged near the first and second side ends, upon mounting the electronic component by soldering the lower electrode, solder easily penetrate into the depression, thus permitting improvement in operability in soldering.

According to the invention, since a frame enclosing the surrounding of the circuit element and composed of a good heat conductor is provided in contact with the upper electrode, heat generated from the circuit element is radiated via the frame. Therefore, the heat radiation performance of the electronic component can be further improved.

### Brief Description of the Drawings

[FIG. 1] is a perspective sectional view showing an electronic component of a first embodiment of the present invention.
[FIG. 2] is a top view showing the electronic component of the first embodiment of the invention.
[FIG. 3] is a bottom view showing the electronic component of the first embodiment of the invention.
[FIG. 4] is a bottom view of the electronic component of the first embodiment of the invention with coating omitted.
[FIG. 5] is a process diagram showing one example of a method for manufacturing the electronic component of the first embodiment of the invention.
[FIG. 6] is a top view showing an electronic component of a second embodiment of the invention.
[FIG. 7] is a bottom view showing the electronic component of the second embodiment of the invention.
[FIG. 8] is a bottom view of the electronic component of the second embodiment of the invention with coating omitted.
[FIG. 9] is a top view showing an electronic component of a third embodiment of the invention.
[FIG. 10] is a bottom view showing the electronic component of the third embodiment of the invention.
[FIG. 11] is a bottom view of the electronic component of the third embodiment of the invention with coating omitted.
[FIG. 12] is a perspective sectional view showing an electronic component of a fourth embodiment of the invention.
[FIG. 13] is a perspective sectional view showing an electronic component of a fifth embodiment of the invention.

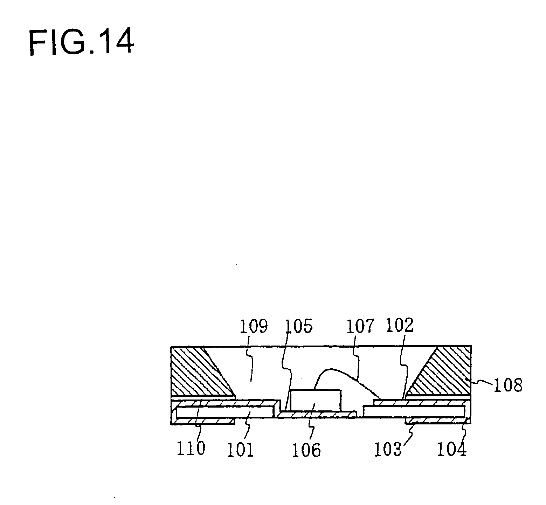

[FIG. 14] is a sectional view showing a conventional electronic component.

### Lists of Reference Symbols

1 Surface-mounted LED
2 Circuit board
3 Frame
4 Electrode (nonpolar)
5, 6 Electrodes (polar)
7, 106 LED elements
8, 9, 107 Thin metal wires
10 opening
11 Transmissive resin
12 Insulating substrate
13, 14 Through holes
15 Electrode (for heat radiation)
16, 17 Electrodes (for wiring)
18 Depression
19 Coating
20 Side surface
21 Cut surface
22 Empty space
23 Coating material
24 Insulating layer
25 Adhesive
26 Aluminum thin plate
27 Frame aggregate
28 Groove
29 Board aggregate
30 Dicing saw
31, 32 Ground electrodes
41 Side surface

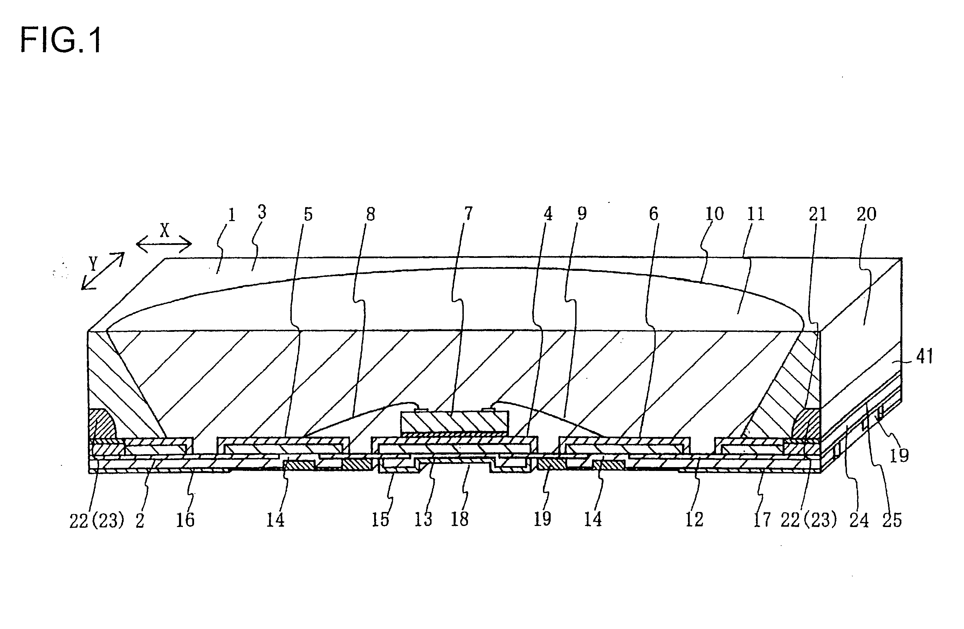

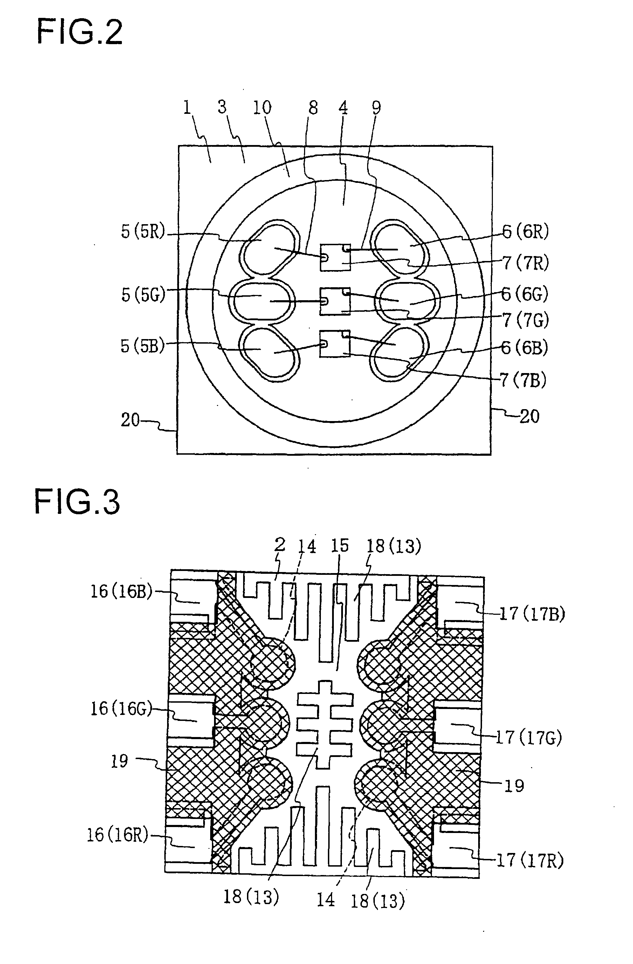

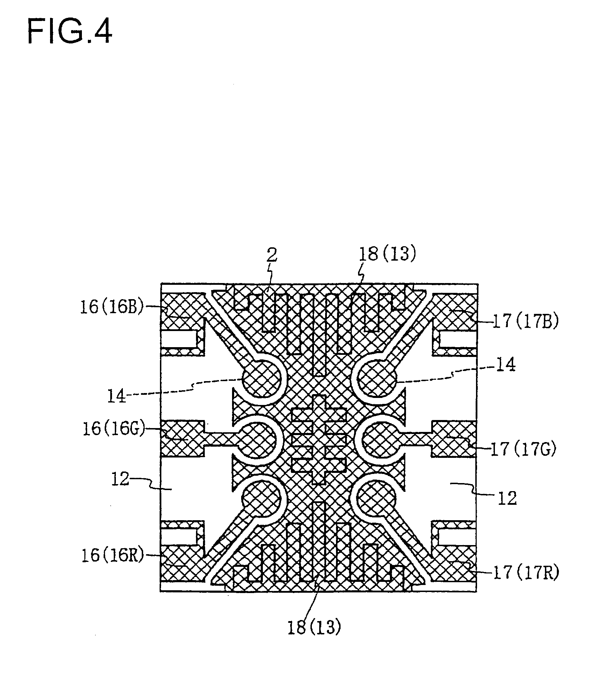

Hereinafter, the embodiments of the present invention will be described with reference to the accompanying drawings. FIG. 1 is a perspective sectional view showing a surface-mounted LED (light-emitting diode) 1 as an electronic component of a first embodiment. FIG. 2 is a top view showing a state of the surface-mounted LED 1 with transmissive resin 11 omitted. FIG. 3 is a bottom view showing the surface-mounted LED 1. FIG. 4 is a bottom view showing a state of FIG. 3 with coating 19 (hatched portions) omitted.

The surface-mounted LED 1 is structured to have a frame 3 fixed on the upper surface of a circuit board 2. The frame 3 has an opening 10 vertically penetrating therethrough, and is disposed on the circumference portion of the circuit board 2. In the opening 10, a nonpolar electrode 4 (upper electrode) and polar electrodes 5 and 6 are disposed. The electrodes 4, 5, and 6 are formed on the upper surface side of an insulating substrate 12 of the circuit board 2. The electrode 5 has either of positive and negative polarities, while the electrode 6 has the other polarity. The electrode 5 has electrodes 5R, 5G, and 5B respectively in correspondence with a plurality of LED elements 7 to be described later. The electrode 6 has electrodes 6R, 6G, and 6B respectively in correspondence with the LED elements 7. The electrode 4 is electrically separated from the electrodes 5 and 6 and is nonpolar (neutral), having no polarity.

The plurality of electrodes 5 (5R, 5G, and 5B) and 6 (6R, 6G, and 6B) respectively having positive and negative polarities are arranged on the upper surface of the circuit board 2 inside the opening 10 of the frame 3. The nonpolar electrode 4 is arranged in a region other than the electrodes 5 and 6 inside the opening 10 of the frame 3, and is also arranged between the lower surface of the frame 3 and the circuit board 2. That is, the electrode 4 is formed to extend over a wide range in such a manner as to cover almost the entire upper surface of the circuit board 2 excluding the electrodes 5 and 6 and insulating grooves therearound.

On the nonpolar electrode 4, an LED element 7 as a circuit element is loaded. One electrode of the LED element 7 is connected to the polar electrode 5 with a thin metal wire 8. The other electrode of the LED element 7 is connected to the polar electrode 6 with a thin metal wire 9. The opening 10 is filled with transmissive resin 11, which encapsulates the LED element 7 and the thin metal wires 8 and 9.

In the insulating substrate 12 of the circuit board 2, a through hole 13 is provided below the electrode 4, and through holes 14 are provided below the electrodes 5 and 6. On the lower surface side of the insulating substrate 12, electrodes 15, 16, and 17 are formed. The electrode 16 has electrodes 16R, 16G, and 16B respectively in correspondence with the LED elements 7. The electrode 17 has electrodes 17R, 17G, and 17B respectively in correspondence with the LED elements 7.

The electrode 15 (lower electrode) is connected to the electrode 4 via the through hole 13. The electrodes 5R, RG, and 5B and the electrodes 16R, 16G, and 16B are connected together via the through hole 14. Moreover, the electrodes 6R, 6G, and 6B and the electrodes 17R, 17G, and 17B are connected together via the through hole 14.

FIG. 4 shows by cross-hatching the electrodes 16 (16R, 16G, and 16B) and 17 (17R, 17G, and 17B) connected to the polar electrodes 5 and 6 and the electrode 15 connected to the nonpolar electrode 4. The electrodes 16 (16R, 16G, and 16B) and 17 (17R, 17G, and 17B) connected to the polar electrodes 5 and 6 are mainly for wiring and function as polar electrodes. The electrode 15 connected to the nonpolar electrode 4 is mainly for heat radiation and functions as a nonpolar electrode.

On the electrode 15 for heat radiation, a depression 18 is formed on which a planar shape of the through hole 13 provided in the insulating substrate 12 is reflected. The through hole 13 is formed by microfabrication through laser processing after the electrode 4 is provided on the insulating substrate 12. Thereafter, the electrode 15 is formed on the lower surface of the insulating substrate 12, whereby the electrodes 4 and 15 are connected on the upper surface of the through hole 13, thereby forming the depression 18 in the shape along the through hole 13. With the depression 18, a geometric pattern is formed on the rear surface of the circuit board 2.

The width of the depression 18 can be formed in the size of 0.1 mm to 0.5 mm by forming the through hole 13 by the microfabrication through laser processing. Therefore, forming the geometric pattern on metal by machining such as drilling makes it difficult to make the width narrower than approximately 0.5 mm, but the width of the depression 18 can be formed narrowly by laser processing.

For the insulating substrate 12, liquid crystal polymer, insulating resin, glass epoxy, ceramic, or the like can be used. The use of the liquid crystal polymer for the insulating substrate 12 is preferable since it is suitable for microfabricatioin. The thickness of the insulating substrate 12 can be selected from a range between 0.01 mm and 0.1mm, considering strength, insulation performance and heat radiation performance. Setting the thickness of the insulating substrate 12 at, for example, 0.025 mm is preferable since it can maintain strength, insulation performance, and heat radiation performance high.

The electrode 15 for heat radiation is directly connected to the nonpolar electrode 4 via a large number of through holes 13, thus permitting heat generated at the LED elements 7 to be efficiently radiated via the electrode 15 for heat radiation. Since this promotes heat radiation of the LED elements 7, deterioration in light emission efficiency due to temperature increase of the LED elements 7 decreases, permitting providing high brightness proportional to the amount of current. Therefore, effect of improving the functionality of the surface-mounted LED 1 and improving the life can be provided.

The electrodes 16 and 17 for wiring excluding terminal sections are, as shown in FIG. 3, coated with the insulating coating 19. The electrode 15 for heat radiation can be partially coated with the insulating coating 19, but, for the purpose of increasing heat radiation performance, is all exposed without being coated with the insulating coating 19.

The terminal sections of the electrodes 16 and 17 for wiring are fixed to terminal sections of a different circuit board with a conducting material such as solder. The electrode 15 for heat radiation is also fixed to a terminal section or a heat sink section of a different circuit board with a conducting material such as solder.

The frame 3 is formed of a material having excellent heat conductivity, and aluminum is used in this embodiment, but magnesium or any other metal material can also be used. Moreover, instead of a metal material, a member having a resin surface or a ceramic surface coated with a metal material, a member having a plurality of metal materials or ceramic materials coupled together with an adhesive material such as resin or metal, a member having metal dispersed in resin, or the like can also be used. Moreover, the frame 3 may be composed of resin only.

The side surface 41 of the surface-mounted LED 1 on the side on which the terminal sections of the electrodes 16 and 17 are exposed is, as shown in FIG. 1, composed of the same surface as the side surface 20 of the frame 3, and at the lower section of the frame 3, empty spaces 22 are formed which is composed of grooves. The empty space 22 is formed by a cut surface 21 over the side surface 20 and the lower surface of the frame 3. The empty space 22 formed by the cut surface 21 is shaped into a quarter-circle in cross section, but may be shaped into a different shape such as a triangle or a rectangle in cross section as long as the insulating distance can be maintained.

In the empty space 22 formed by the cut surface 21 at a corner portion over the side surface 20 and the lower surface of the frame 3, a coating material 23 is filled. The coating material 23 is composed of an insulating material, but as later described in the other embodiment, may be composed of a conducting material when the coating material 23 is formed on the cut surface 21 in a predetermined thickness without filling the empty space 22. Moreover, the cut surface 21 may be exposed without being coated.

The frame 3 is fixed to the circuit board 2 with an adhesive 25 so that its lower surface makes direct contact with the nonpolar electrode 4. On the outer circumference portion of the upper surface of the circuit board 2, a depression is formed for arranging the adhesive 25 in almost the same plane as the upper surface of the nonpolar electrode 4. The adhesive 25 is stored in this depression, which permits preventing direct contact between the frame 3 and the circuit board 2 from being hindered by the thickness of the adhesive 25. The lower surface side of the depression for arranging the adhesive 25 is covered by an insulating layer 24 such as insulating resin.

For the electrodes 4, 5, 6, 15, 16, and 17 of the surface-mounted LED 1 configured in this manner, metal or alloy with favorable conductivity and heat radiation performance, such as Cu, Fe, Al, or the like is used. Moreover, it is preferable that surfaces of the electrodes 4, 5, 6, 15, 16 and 17 be plated with Ni, Au, Ag, Pd, Sn, or plated with these superimposed plurally. Furthermore, for the thin metal wires 8 and 9 electrically connecting together the respective electrodes of the LED elements 7 and the electrodes 5 and 6, Ag, Au, Al, or the like is used.

In the surface-mounted LED 1 with the above configuration, application of a predetermined voltage to the polar electrodes 5 and 6 through the terminal sections of the electrodes 16 adn17 causes current flow to the LED elements 7 through the thin metal wires 8 and 9. As a result, the LED elements 7 emit light on their unique wavelength. The light emitted from the LED elements 7 is extracted to the outside through the transmissive resin 11.

A plurality of LED elements 7 are provided, and thus light-emitting diodes for three primary colors, i.e., red, green, and blue can be used. Instead of these, light-emitting diodes for two colors or a light-emitting diode for a single color may be used, or light emitting diodes for four or more colors can also be used. When the LED elements 7 have a plurality of colors and they emit light simultaneously, the different colors are mixed together and extracted to the outside through the transmissive resin 11.

The upper surface of the transmissive resin 11 may be partially notched or another member may be added to the upper surface to thereby form the upper surface into a shape of a semicircular column or hemisphere. This condenses the light emitted from the LED elements 7 and further improves efficiency of upward light emission.

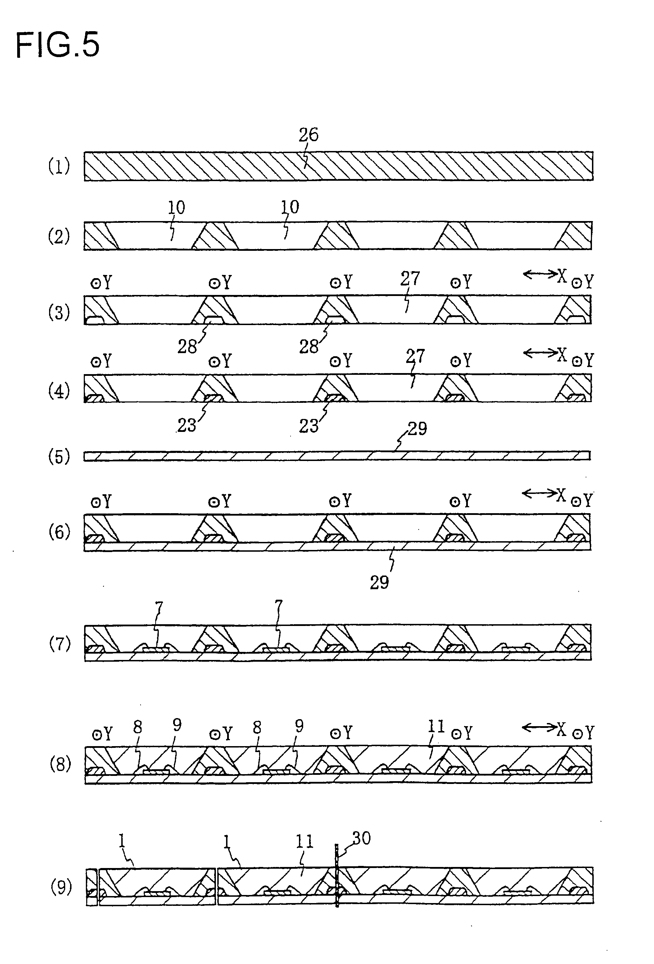

FIGS. 5(1) to (9) are flow diagrams showing representative processes of manufacturing the surface-mounted LED 1. Here, structure of the circuit board 2 and the frame 3 are partially omitted and thus simply expressed. In the first process shown in FIG. 5(1), an aluminum thin plate 26 is supplied. The thickness of the aluminum thin plate 26 is selected from among ranges 0.5 mm to 2 mm or 0.5 mm to 3 mm.

In the second process shown in FIG. 5(2), in the thin plate 26 of aluminum, a plurality of bowl-shaped openings 10 are formed in a matrix form in X and Y directions in such a manner as to penetrate vertically through the thin plate 26 (see FIG. 1). The opening 10 can be formed by etching, drilling, or the like. The aluminum thin plate 26 formed with the openings 10 forms a frame aggregate 27 which is formed with a plurality of frames 3 (see FIG. 1).

The frame aggregate 27 is, as described later, cut along an expected X-direction cut line and an expected Y-direction cut line which crosses the X direction at a predetermined angle. In the above example, the direction parallel to the paper surface of FIG. 5 is defined as the X direction, and the direction orthogonal to the paper surface is defined as the Y direction (the expected Y-direction cut line is shown by a symbol including a dot at the circle center in the figure).

In the third process shown in FIG. 5(3), on the lower surface of the aluminum thin plate 26 formed with the openings 10, grooves 28 in line with the expected Y-direction cut line are formed in a predetermined depth. The grooves 28 are wider than a cut width to be described later. The groove 28 can be formed by any of a variety of known methods, such as chemical processing through etching and machining with a dicing saw. The depth of the groove 28 may be in any depth as long as it does not penetrate through the thin plate 26.

In the fourth process shown in FIG. 5(4), the coating material 23 is filled in the grooves 28 formed in the third process. To completely cover the grooves 28, an insulating material such as resist is used as the coating material 23.

In the fifth process shown in FIG. 5 (5), a circuit board aggregate 29 is supplied. By cutting this circuit board aggregate 29 along the expected X and Y direction cut lines, a plurality of circuit boards 2 (see FIG. 1) are formed.

In the sixth process shown in FIG. 5(6), the frame aggregate 27 and the circuit board aggregate 29 are fixed with the expected cut lines in line. The fixation of the frame aggregate 27 and the circuit board aggregate 29 is performed with the insulating adhesive 25. For a portion where no insulation is required, the fixation may be done by using a conductive jointing material such as a conductive adhesive or solder, or other fixing means may be used.

In the seventh process shown in FIG. 5 (7), the LED elements 7 are loaded on the circuit board aggregate 29 and wiring of the thin metal wires 8 and 9 are performed through wire bonding.

In the eighth process shown in FIG. 5 (8), the transmissive resin 11, which transmits light, is filled in the openings 10 so that the LED elements 7 and the thin metal wires 8 and 9 are embeded, thereby curing the opening 10.

In the ninth process shown in FIG. 5 (9), the frame aggregate 27 and the circuit board aggregate 29 are cut along the expected X-direction and Y-direction cut lines by using a dicing saw 30. As a result, a plurality of surface-mounted LEDs 1 are obtained separately.

In this manner, the surface-mounted LED 1 as the electronic component shown in FIGS. 1 and 4 described above is manufactured. The surface-mounted LED is formed with an upper surface thereof sized several millimeters square and with a thickness of approximately 0.3 mm to 3 mm. Four side surfaces of this surface-mounted LED 1 is cut simultaneously with the dicing saw 30; therefore, the circuit board 2 and the frame 3 fixed thereto have four side surfaces 41 (common side surfaces) composed of the same surface.

To individually cut the frames 3 and the LED elements 7 arrayed in line with the dicing saw 30, opposing two side surfaces are cut simultaneously with the dicing saw 30. Therefore, the circuit board 2 and the frame 3 fixed thereto have two opposing side surfaces (common side surfaces) formed of the same surface.

In the ninth process of cutting with the dicing saw 30, the side surface of the surface-mounted LED 1 on the side on which the terminal sections connected to the polar electrodes 5 and 6 are drawn is formed. At this point, metal burr may be formed as a result of cutting along the lower edge of the cut surface of the metallic frame 3 (side surface 20 of the frame 3). However, the presence of the empty space 22 created by the grooves 28 formed in the third process ensures a predetermined distance between the frame 3 and the circuit board 2. This therefore previously avoids the metal burr from making contact with the terminal sections connected to the electrodes 5 and 6 of the circuit board 2.

Although the insulation distance between the frame 3 and the circuit board 2 can be ensured with the empty space 22 only, filling the insulating coating material 23 in the empty space 22 enhances the insulation and also suppresses occurrence of metal burr. The insulating coating material 23 may be applied to the empty space 22. Moreover, on the upper surface of the circuit board 2 facing the empty space 22, the insulating layer 24 is formed, and the insulating adhesive 25 is located further thereon. Thus, the effect of the metal burr can be more reliably eliminated.

Moreover, the terminal sections connected to the polar electrodes 5 and 6 of the circuit board 2 are arranged on the lower surface of the circuit board 2. Thus, the lower surface of the frame 3 and the terminals can be arranged furtherer away from each other to avoid the risk of contact of the metal burr. Further, since the region where the frame 3 on the upper surface of the circuit board 2 is loaded serves as the electrode 4, even when the metal burr makes contact with the upper surface of the circuit board 2, there is almost no effect on the circuit.

Heat generated at the LED elements 7 is effectively radiated on the upper and lower surfaces of the circuit board 2. First, on the upper surface of the circuit board 2, the heat is radiated over a wide range by the non-polar electrode 4 (upper electrode) and the metal frame 3 directly making contact with the electrode 4. On the lower surface of the circuit board 2, the heat is radiated over a wide range through the electrode 15 (lower electrode) directly connected through the through hole 13 of the insulating substrate to the electrode 4.

As shown in FIG. 4, the electrode 15 for heat radiation formed on the lower surface of the surface-mounted LED 1 extends from the central part of the lower surface to its both side ends, occupying a wide area. Specifically, the electrode 15 for heat radiation is formed over a range from, of an opposing pair of side ends 20A and 20B on the lower surface of the circuit board 2, one side end 20A (first side end) to the other side end 20B (second side end).

Near each of the side ends 20A and 20B of the electrode 15, a group of depressions 18 collected in a comb-like form along a planar shape of the through hole 13 is arranged. Moreover, also at a central part of the electrode 15, i.e., a central part between the side ends 20A and 20B, a group of depressions 18 collected in the form of fish bone is arranged.

With the depressions 18, a step can be formed at the electrode 15 to thereby increase the heat radiation area of the electrode 15. Moreover, upon mounting the surface-mounted LED 1 by soldering the electrode 15, the depressions 18 increase the solder joint area, which permits improvement in joint strength. Further, since solder is embedded in the depressions 18 during soldering, the metal volume increases, which enlarges a heat conduction path, resulting in smooth heat radiation.

Moreover, since the depressions 18 are arranged near the side ends 20A and 20B, the solder easily penetrates through the depressions 18. Therefore, operability in soldering the surface-mounted LED 1 can be improved.

The radiation performance of the electrode 15 can be improved by filling in the depressions 18 not only solder but a conducting material with excellent heat conductivity upon fitting the surface-mounted LED 1. Here, if soldering is performed with solder filled in the depressions 18, a process of filling in the depressions 18 a highly heat conductive material and a processing of soldering the surface-mounted LED 1 can be combined. Therefore, operability for a process of assembling a device loaded with the surface-mounted LED 1 can be improved.

The groups of depressions 18 are respectively and independently arranged at the side end 20A, the side end 20B, and the central part located on the lower surface of the circuit board 2 but these three groups of depressions 18 may be formed in connection with each other. Specifically, the depressions 18 disposed immediately below the LED element 7 can be extended from the center to the side ends so as to be linked to the side ends 20A and 20B located on the lower surface of the circuit board 2. Extending the depressions 18 in this manner can further improve the heat radiation performance provided by the conducting material filled in the depressions 18.

On the lower surface of the circuit board 2, the terminal sections of the electrodes 16 and 17 are drawn out to a pair of opposing side ends 20C and 20D (third and fourth side ends) extending in a direction crossing the side ends 20A and 20B. As a result, the terminal sections of the electrodes 16 and 17 connected to the polar electrodes 5 and 6 are so arrayed as to extend along the side ends 20C and 20D.

Of the electrodes 15, 16, and 17 disposed on the lower surface of the circuit board 2, the electrode 15 for heat radiation has a largest area. Moreover, the area of the electrode 15 for heat radiation is wider than the area of each of the electrodes 16 and 17 which are connected to the electrodes 5 and 6 having positive and negative polarities and which are located on the lower surface, and in addition, is wider than a total area of the electrodes 16 and 17.

The frame 3 includes around the opening 10 a circumference surface widening upward. Light emitted from the LED element 7 is reflected by the circumference surface of the frame 3. Therefore, the circumference surface of the frame 3 functions as a reflective surface, and can improve the light use efficiency.

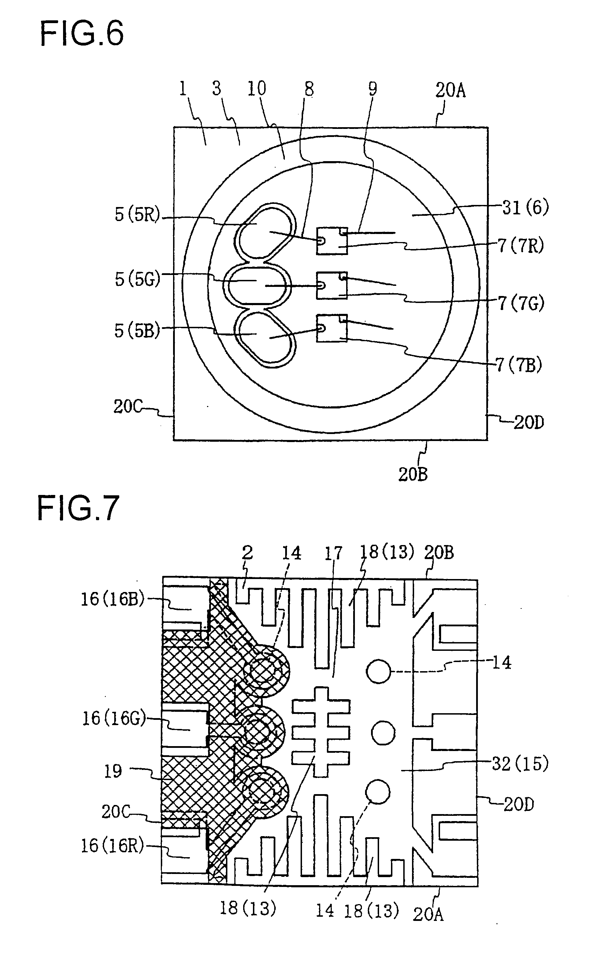

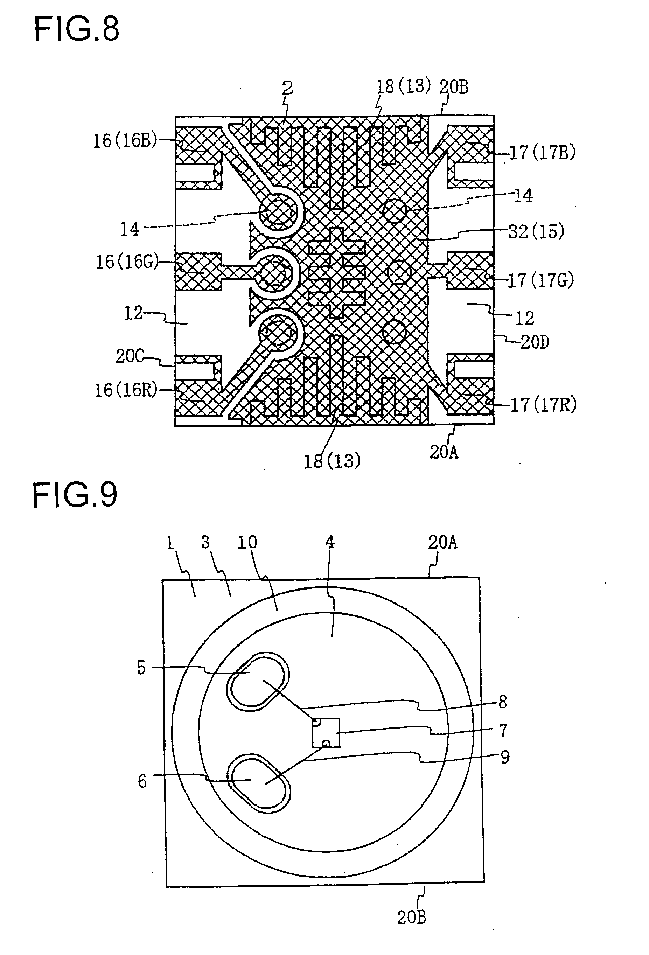

Next, FIG. 6 is a top view showing a surface-mounted LED 1 as an electronic component of the second embodiment. FIG. 7 is a bottom view showing the surface-mounted LED 1. FIG. 8 is a bottom view showing a state of FIG. 7 with coating 19 (hatched portion) omitted. For explanatory purposes, portions the same as those in the first embodiment shown in FIGS. 1 to 4 described above are provided with the same numerals.

In this embodiment, the electrode 4 (see FIG. 1) is integrated with the electrode 6 to form a ground electrode 31. Moreover, the electrodes 15 and 17 are integrated to form a ground electrode 32. As a result, the terminal section of the electrode 16 is provided along the side end 20C (third side end), and the electrode 15 (lower electrode) is so provided as to extend to the side end 20D (fourth side end). Other portions are the same as those of the first embodiment.

One terminal of the LED element 7 is connected to the electrode 5, and the other terminal thereof is connected to the ground electrode 31. The ground electrodes 31 and 32 are connected together via the through holes 13 and 14 (see FIG. 1), and the ground electrode 32 is connected to a ground section of the device loaded with the surface-mounted LED 1.

According to this embodiment, the same effects as those of the first embodiment can be provided. Moreover, heat generated at the LED element 7 is radiated via the ground electrodes 31 and 32. Thus, a wide heat radiation area can be ensured, permitting further improvement in heat radiation performance of the surface-mounted LED 1.

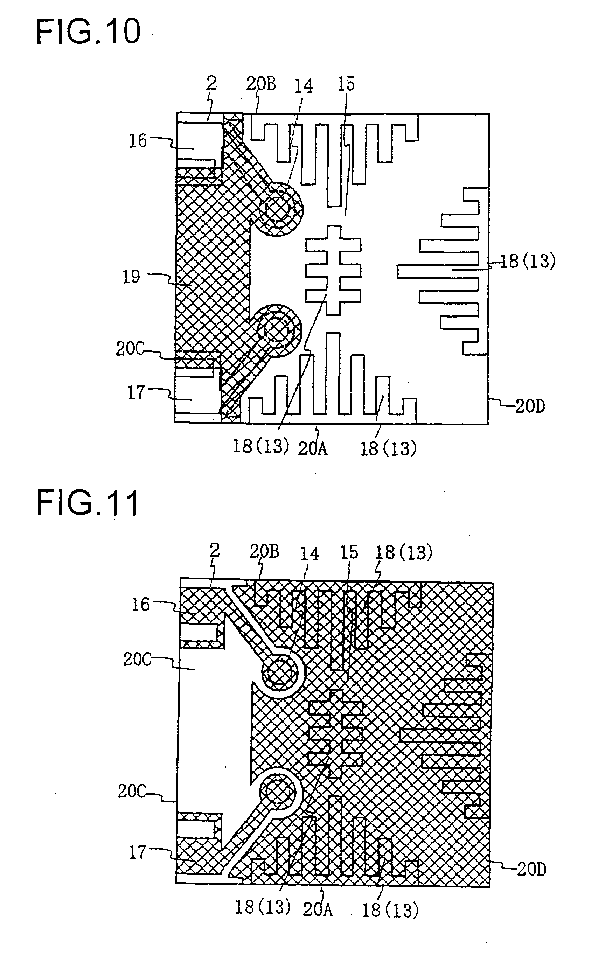

Next, FIG. 9 is a top view showing a surface-mounted LED 1 as an electronic component of the third embodiment. FIG. 10 is a bottom view showing the surface-mounted LED 1. FIG. 11 is a bottom view showing a state of FIG. 10 with coating 19 (hatched portion) omitted. For explanatory purposes, portions the same as those in the first embodiment shown in FIGS. 1 to 4 described above are provided with the same numerals.

In this embodiment, the terminal sections of the electrodes 16 and 17 are arranged along the side end 20C (third side end) of the circuit board 2, and the electrode 15 on the lower surface side is so provided as to extend to the side end 20D (fourth side end) of the circuit board 2. To one LED element 7, a voltage is applied via the terminal sections of the electrodes 16 and 17 along the side end 20C. Moreover, at the side end 20D, the through hole 13 is provided which connects together the electrode 4 and the electrode 15. As a result, the depressions 18 of a comb-like shape along a planar shape of the through hole 13 are formed along the side end 20D. Other portions are the same as those of the first embodiment.

According to this embodiment, the same effects as the first embodiment can be provided. Moreover, wide areas of the electrodes 4 and 15 can be ensured, permitting further improvement in the heat radiation performance of the surface-mounted LED 1. In particular, when the number of LED elements 7 loaded is small, the terminal sections can easily be collected at one side of the surface-mounted LED 1, thus permitting improvement in the heat radiation performance to be achieved by this embodiment.

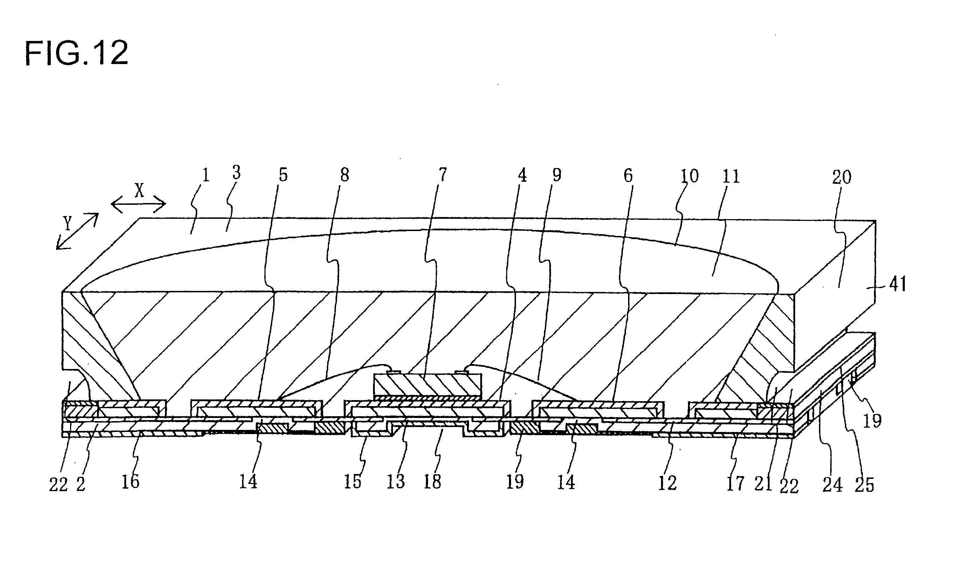

Next, FIG. 12 is a perspective view showing a surface-mounted LED 1 as an electronic component of the fourth embodiment. For explanatory purposes, portions the same as those of the first embodiments shown in FIGS. 1 to 4 described above are provided with the same numerals. This embodiment differs form the first embodiment in that the coating material 23 (see FIG. 1) filled in the empty space 22 is omitted. This embodiment is the same as the first embodiment in the other configurations.

This embodiment can be carried out by omitting the resin filling process as the fourth process in the manufacturing processes of the surface-mounted LED 1 shown in FIG. 5 described above. Since the coating material 23 is omitted, the insulation performance deteriorates compared to the first embodiment, but good practicability can be achieved by ensuring the insulation distance between the frame 3 and the circuit board 2 by the empty space 22.

At the time of forming the grooves 28 in the third process of FIG. 5 described above, the depth of the grooves 28 may be made smaller than the thickness of the circuit board 2. However, making the depth of the grooves 28 larger than or equal to the thickness of the circuit board 2 is preferable since it improves the insulation performance. Moreover, the depth of the grooves 28 may be set at such a depth that does not permit penetration through the frame 3. When the circuit board 2 is fixed at a section where soldering paste is applied by using a metal mask or the like, the depth of the grooves 28 may be set so that it becomes higher (deeper) than the thickness (height) of this soldering paste. This can avoid insulation failure as a result of soldering, which is more preferable.

Ground electrodes 31 and 32 (see FIGS. 6 and 7) the same as those of the second embodiment may be provided, and terminal sections of the electrodes 16 and 17 may be provided at the side end 20D as is the case with the third embodiment.

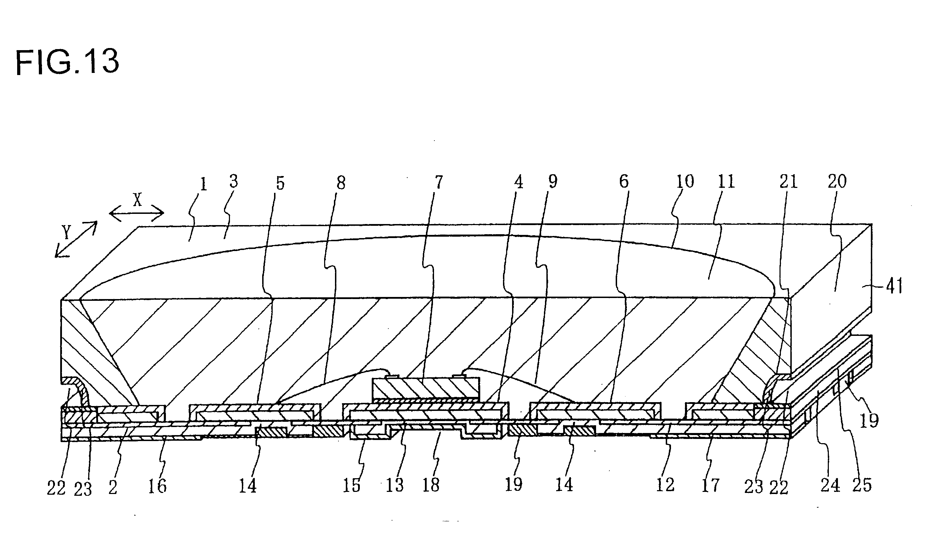

Next, FIG. 13 is a perspective view showing a surface-mounted LED 1 as an electronic component of the fifth embodiment. For explanatory purposes, portions the same as those of the first embodiments shown in FIGS. 1 to 4 described above are provided with the same numerals. This embodiment differs form the first embodiment in that the coating material 23 (see FIG. 1) filled in the empty space 22 is a coating of a predetermined thickness. This embodiment is the same as the first embodiment in the other configurations.

Since the insulation distance can be ensured with the empty space 22 and the coating material 23, the insulation performance equivalent to that of the first embodiment can be ensured. The coating material 23 may be an insulating material as is the case with the first embodiment, or may be a conducting material.

Using a harder material for the coating material 23 than a material forming the frame 3 is preferable since it suppresses occurrence of metal burr. When a conducting material is used as the coating material 23, a metal material capable of preventing the occurrence of metal burr in the frame 3 can be used. As such a metal material, a hard metal material of nickel, chrome, titanium, or the like can be used.

Moreover, when a main material of the frame 3 is formed of aluminum, magnesium, or the like, the surface of the frame 3 may be subjected to chemical conversion treatment (alumite treatment) to form the coating material 23 composed of an insulating body. For example, when the frame 3 is of aluminum, the Vickers hardness (Hv) after typical alumite treatment is 200 to 250, and the Vickers hardness (Hv) after hard alumite treatment is 400 to 450. Therefore, the alumite portion can be used as the coating material 23.

Moreover, the typical film thickness of alumite is approximately 20 µm, but can be thickened to approximately 100 µm. Thus, the use of thick-filmed alumite as the coating material 23 can improve effect of insulation and effect of preventing metal burr.

Ground electrodes 31 and 32 (see FIGS. 6 and 7) the same as those of the second embodiment may be provided, and terminal sections of the electrodes 16 and 17 may be provided at the side end 20D as is the case with the third embodiment.

In the first to fifth embodiments, the invention is also applicable to an electronic component having as a heat-generating element a circuit element which has resistance components such as a chip resistor, an IC, etc. in addition to the LED element.

### Industrial Applicability

According to the present invention, the invention can be used for an electronic component having a frame fixed on the upper surface of a circuit board. More specifically, the invention is applicable to a surface-mounted LED used as a light source for switch inner illumination, an LED display, a backlight light source, an optical printer head, a camera flash, or the like.

## Claims

1. An electronic component comprising a circuit board having a plurality of electrodes on upper and lower surface of an insulating substrate and a thermogenic circuit element fixed to an upper surface of the circuit board, the electronic component further comprising:
an upper electrode on which the circuit element is placed;
a through hole penetrating through the insulating substrate; and
a lower electrode formed on a lower surface side in a range from a first side end of the circuit board to a second side end thereof opposing the first side end, the lower electrode being connected to the upper electrode via the through hole.

2. The electronic component according to claim 1,
wherein the upper electrode and the lower electrode are adapted to be electrically nonpolar.

3. The electronic component according to claim 2,
wherein terminal sections of a plurality of polar electrodes are arranged along opposing third and fourth side ends extending in a direction crossing the first and second side ends.

4. The electronic component according to claim 3,
wherein the lower electrode has a wider area than each of the polar electrodes.

5. The electronic component according to claim 2,
wherein the terminal sections of the polar electrodes are arranged along the third side end extending in the direction crossing the first and second side ends, and the lower electrode is provided in a manner such as to extend to the fourth side end opposing the third side end.

6. The electronic component according to claim 5,
wherein the upper electrode and the lower electrode are grounded.

7. The electronic component according to any of claims 1 to 6,
wherein a depression in a shape along the through hole is formed on a surface of the lower electrode.

8. The electronic component according to claim 7,
wherein a joint surface between the upper electrode and the lower electrode is composed of an upper surface of the through hole.

9. The electronic component according to claim 7,
wherein the depression is arranged near the first and second side ends.

10. The electronic component according to any of claims 1 to 6,
wherein a frame enclosing the surrounding of the circuit element and composed of a good heat conductor is provided in contact with the upper electrode.

11. The electronic component according to claim 10,
wherein the circuit element is composed of an LED element, and emitted light of the LED element is reflected by the frame
